## Europäisches Patentamt

## European Patent Office

## Office européen des brevets

(11) Publication number: **0 086 915**
**B1**

(12) **EUROPEAN PATENT SPECIFICATION**

(45) Date of publication of patent specification: **08.02.89**

(51) Int. Cl.⁴: **H 01 L 21/76, H 01 L 23/52**

(21) Application number: **82306124.7**

(22) Date of filing: **17.11.82**

(54) **Semiconductor device having conductor lines connecting the elements.**

(30) Priority: **20.11.81 JP 186528/81**

(43) Date of publication of application:
**31.08.83 Bulletin 83/35**

(45) Publication of the grant of the patent:
**08.02.89 Bulletin 89/06**

(84) Designated Contracting States:
**DE FR GB**

(56) References cited:
**EP-A-0 036 764**
**DE-A-2 643 016**
**US-A-4 037 306**
**US-A-4 187 516**
**US-A-4 255 207**

**JAPANESE JOURNAL OF APPLIED PHYSICS,
vol. 19, supplement 19-1, 1980, pages 175-180,
Tokyo, JP; T. FUKUSHIMA et al.: "A high speed
Schottky 4 k-bit PROM using diffused eutectic
aluminum process (Deap)"**

(73) Proprietor: **FUJITSU LIMITED
1015, Kamikodanaka Nakahara-ku
Kawasaki-shi Kanagawa 211 (JP)**

(72) Inventor: **Kimoto, Masayoshi
38-6, Chitoseshinmachi Takatsu-ku
Kawasaki-shi Kanagawa 213 (JP)**
Inventor: **Mafune, Yasuhiko
3-7-1, Chiyogaoka Asao-ku
Kawasaki-shi Kanagawa 215 (JP)**
Inventor: **Sugo, Yasuhisa
3-25-13, Minamikoiwa Edogawa-ku
Tokyo 133 (JP)**

(74) Representative: **Skone James, Robert Edmund
et al
GILL JENNINGS & EVERY 53-64 Chancery Lane
London WC2A 1HN (GB)**

## Description

The present invention relates to a semiconductor device and, more particularly, to an integrated circuit (IC) having a groove isolation structure wherein a groove is formed in the semiconductor body and an insulating layer is formed on the surface of the groove.

Recently, attempts have been made to increase the number of elements of large-scale integrated circuits (e.g. the number of memory cells of a semiconductor memory IC) and, simultaneously, to increase the IC operating speed. An increased number of elements of an IC, however, means an increased number of conductor lines connecting the elements, which results in increased stray capacity of the conductor lines. Therefore, although the operating speed of active elements can be increased, the increased stray capacity of the conductor lines substantially impedes the increase of the IC operating speed.

US—A—4,037,306 describes an integrated circuit structure in which elements are formed in a semiconductor body with conductor lines connecting the elements. The elements are isolated electrostatically from one another by means of an isolation structure comprising grooves surrounding the elements.

EP—A—0 036 764 also describes a semiconductor device having elements embedded in a semiconductor body with a V-groove insulating isolation structure provided around the elements.

In each case the conductor lines extend over the isolation structure leading to large stray capacitances which prevent high operating speeds being obtained.

In accordance with one aspect of the present invention, a semiconductor device has a semiconductor body, an isolation structure, elements formed in a portion of the semiconductor body and surrounded by the isolation structure to isolate the elements electrostatically from each other, and conductor lines operatively connecting the elements, and is characterised in that the semiconductor device is provided with an electrostatic separating structure including a groove formed in the semiconductor body under and along those portions of each conductor line extending in regions of the semiconductor body other than the regions in which the elements and the isolation structure are formed, and a filler filling the groove formed in a portion of the semiconductor body, the electrostatic separating structure including an insulating material constituted by the filler or by a layer formed on the filler which contacts the conductor lines.

With this device the stray capacity of conductor lines of the semiconductor device, such as an IC, is reduced by making use of an additional electrostatic separating structure separate from the isolation structure and associated with the conductor lines. Also, the IC operating speed is increased. The groove of the electrostatic separating structure is formed in a portion of the semiconductor body other than that necessary for the elements.

In accordance with a second aspect of the present invention, a method of manufacturing a semiconductor device comprises forming semiconductor elements in a portion of a semiconductor body; forming isolation structures which surround the elements to isolate the elements electrostatically from each other; forming conductor lines on the semiconductor body and is characterised by forming an electrostatic separating structure including a groove formed in the semiconductor body under and along those portions of each conductor line extending in regions of the semiconductor body other than the regions in which the elements and the isolation structure are formed, the groove being filled with a filler, whereby the electrostatic separation structure includes an insulating material constituted by the filler or by a layer formed on the filler which contacts the conductor lines.

Preferably, the electrostatic separating structure is formed at the same time as the formation of the groove isolation structures.

Preferably, the cross-sectional shape of the electrostatic separating structure is the same as or similar to that of the groove isolation structures.

Some examples of devices in accordance with the present invention will now be described and contrasted with a prior art device with reference to the accompanying drawings, in which:-

Figure 1 is a partial circuit diagram of a semiconductor memory IC;

Figure 2 is a partially schematic sectional view of a conventional semiconductor device;

Figure 3 is a partially schematic sectional view of one example of a semiconductor device according to the present invention;

Figure 4 is a partially schematic sectional view of a second example of a semiconductor device according to the present invention; and,

Figure 5 is a partially schematic sectional view of a third example of a semiconductor device according to the present invention.

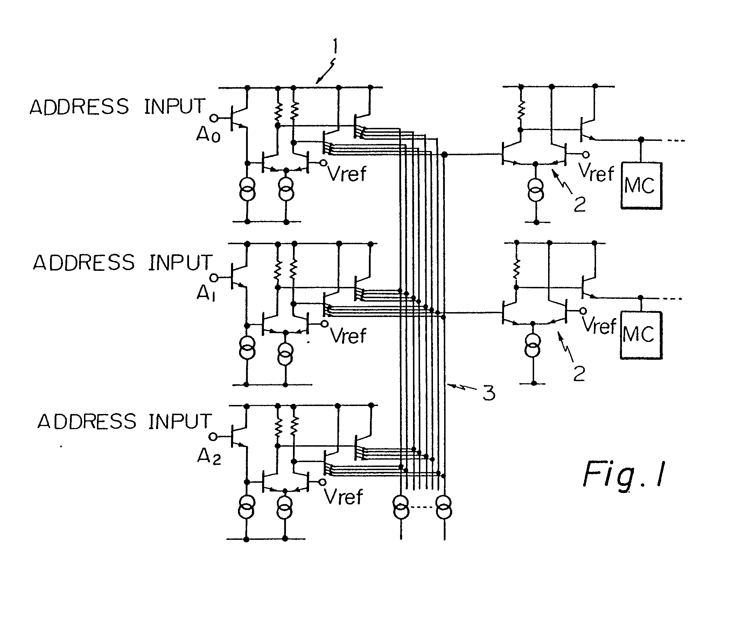

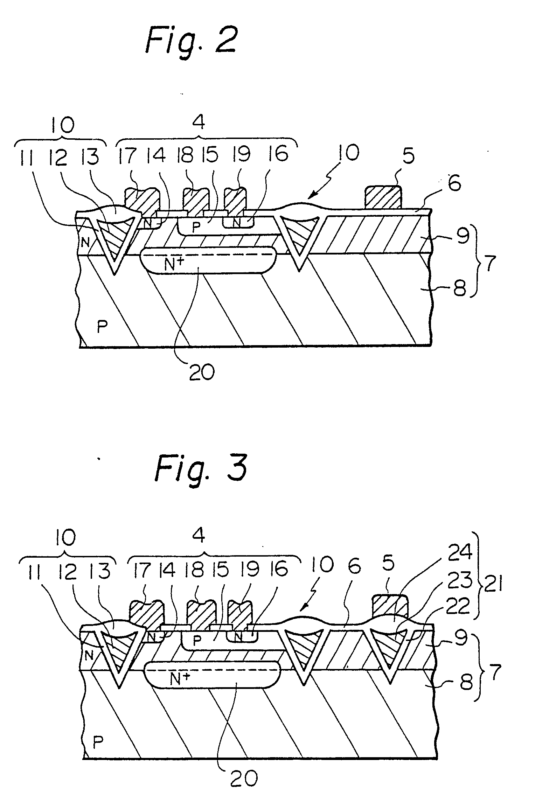

A prior art semiconductor memory IC comprises decoder circuits 1 and driver circuits 2, as illustrated in Figure 1, and conductor lines 3 which meander on the insulating layer formed on the semiconductor body to connect the decoder circuits 1 and the driver circuits 2. The total length of the conductor lines 3 is very long, so the stray capacity of the conductor lines may become large. If a part of the semiconductor memory IC (Figure 1.) is made of a bipolar transistor 4 and a conductor line 5, as illustrated in Figure 2, the conductor line 5 is arranged on an insulating layer 6 formed on the semiconductor body 7 comprising a semiconductor substrate (e.g. a silicon wafer) 8 and an epitaxial layer 9. The bipolar transistor 4 is formed in a portion of the epitaxial layer 9 which is surrounded with a groove isolation structure 10. The groove isolation structure 10 comprises an insulating layer 11 on the surface of a groove (in this case, a V-groove) formed in the semiconductor body, a filled-in polycrystalline silicon material 12, and a relatively thick insulating layer 13. Such a groove isolation structure is referred to as a "VIP" structure or "IOP" structure. The bipolar transistor 4 comprises a collector contact region 14, a base region 15, an emitter region 16, a collector electrode 17, a base electrode 18, and an emitter electrode 19. A buried layer 20 is formed between the substrate 8 and the epitaxial layer 9. Generally, the insulating layer 6 under the conductor line 5 is made of silicon dioxide and has a thickness of approximately 400 nm. Such conductor lines generate a large stray capacity which prevents an increased IC operating speed.

The stray capacity of the conductor lines is very dependent on the thickness of the insulating layer formed between the conductor lines and the semiconductor body. The thicker the insulating layer, the smaller the stray capacity. Accordingly, to reduce the stray capacity of the conductor line 5 in case of Fig. 2, persons skilled in the art may think of making the insulating layer 6 thicker. However, in a case where the thick insulating layer 6 is formed, an aluminum conductor line formed by a vacuum evaporation process may break at a step of an electrode contact hole formed by selectively etching the thick insulating layer. The formation of the thick insulating layer of silicon dioxide involves a heating process at a high temperature for a relatively long period. At this time, the semiconductor crystal is stressed by heating, so that crystal defects may occur. Furthermore, simultaneously the polycrystalline silicon material 12 filled in the V-groove is further oxidized to make a larger bird's beak, so that such bird's beak hinders the fine pattern formation, i.e. prevents the density of an IC from increasing. Moreover, taking such bird's beak into consideration, the base region 15 must be enlarged, whereby the junction capacity between base and collector is increased. Such increase of the junction capacity is one of the causes of delay of the IC operating speed.

Figure 3 illustrates a portion of a semiconductor device, i.e., a bipolar transistor 4 and a conductor line 5 of an IC, according to the present invention. The bipolar transistor 4, semiconductor body 7, and groove isolation structure 10 are the same as those illustrated in Fig. 2. The bipolar transistor 4 comprises a collector contact region 14, a base region 15, an emitter region 16, a collector electrode 17, a base electrode 18, and an emitter electrode 19. The semiconductor body 7 comprises a semiconductor substrate (e.g., a silicon wafer) 8, an epitaxial layer 9 of single crystalline silicon, and a buried layer 20. The groove isolation structure (in this case "VIP" structure) comprises a V-shaped insulating layer 11, a filled-in polycrystalline silicon material 12, and a relatively thick insulating layer 13 which surrounds the bipolar transistor 4 and extends into the semiconductor substrate 8 through the epitaxial layer 9 so as to isolate it from other elements (e.g., bipolar transistors) of the IC, as illustrated in Fig. 3.

In order to reduce the stray capacity of the conductor line 5, an electrostatic separating structure 21 is formed under the conductor line. The electrostatic separating structure 21 comprises a V-shaped insulating layer 22, a filled-in polycrystalline silicon material 23, and a relatively thick insulating layer 24. The V-groove for the separating structure 21 is formed under the conductor line 5 and in a portion of the semiconductor body 7 other than that necessary for the bipolar transistor 4 and other elements. In this case, the sectional shape of the electrostatic separating structure 21 is the same as that of the groove isolation structure 10.

Both structure 10 and 21 are simultaneously formed. After the formation of the epitaxial layer 9 of silicon on the semiconductor substrate 8, the epitaxial layer 9 is thermally oxidized to form an insulating layer 6 of silicon dioxide. A silicon nitride layer (not shown) is formed on the insulating layer 6 by a chemical vapour deposition method. The silicon nitride layer and the insulating layer 6 are selectively removed by a photoetching method to expose portions of the surface of the epitaxial layer 9. Then, the exposed portions of the epitaxial layer 9 are anisotropically etched by a solution of potassium hydroxide and isopropyl alcohol to form V-grooves for the isolation structure 10 and the electrostatic separating structure 21, respectively. The bottoms of the V-grooves penetrate into the semiconductor substrate 8. The V-shaped insulating layers 22 and 11 of silicon dioxide are formed on the surface of the V-grooves by thermally oxidizing the exposed portions of the epitaxial layer 9 and the semiconductor substrate 8 in the V-grooves. A polycrystalline silicon layer is formed on the exposed surfaces of the silicon nitride layer and the insulating layers 22 and 11 so as to fill the V-grooves by a chemical vapor deposition method. The polycrystalline silicon layer is polished to leave portions 23 and 12 of the polycrystalline silicon within the V-grooves. Then, the remaining polycrystalline silicon portions 23 and 12 are thermally oxidized to form the relatively thick insulating layers 24 and 13 of silicon dioxide. This completes the above-mentioned electrostatic separating structure 21 and groove isolation structure 10.

Next, the silicon nitride layer is removed. The base region 15, the collector contact region 14, and the emitter region 16 of the bipolar transistor 4 are formed in accordance with a conventional process. A conductor layer of, e.g., aluminum is formed on the exposed surface and then is selectively removed by a photoetching method to form the collector electrode 17, the base electrode 18, the emitter electrode 19, and the conductor line 5 arranged on the electrostatic separating structure 21. Since the relatively thick insulating layer 24 has a thickness of, e.g., approximately 1 μm (micrometer) and the V-shaped insulating layer 22 has a thickness of, e.g., approximately 500 nm, the stray capacity of the conductor line 5 of Fig. 3 is much smaller than that of the conductor line 5 of Fig. 2. It is possible to form the electrostatic separating structure according to the present invention under all conductor lines and in a portion of the semiconductor body other than that necessary for elements. This allows the stray capacity of the conductor lines of the IC to be substantially reduced. Therefore, the IC operating speed can be increased over that of the case of a conventional IC.

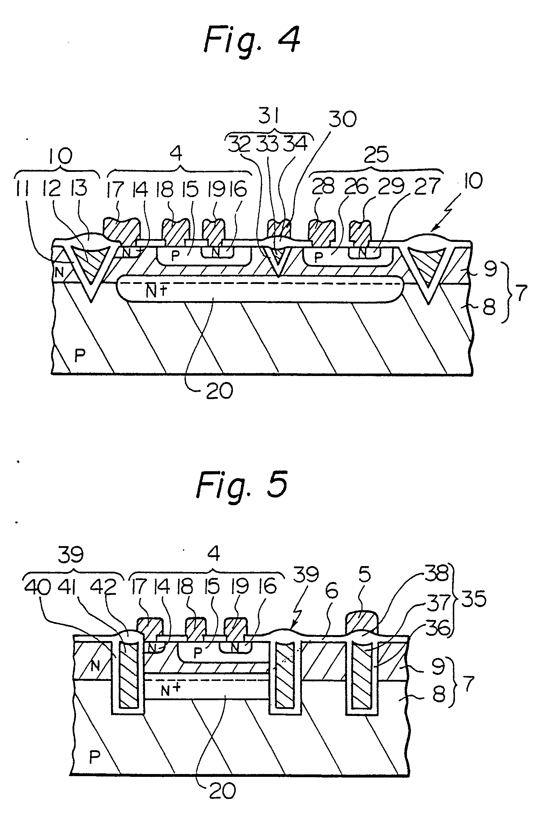

A portion of a semiconductor device (e.g., a bipolar transistor IC) according to another embodiment of the present invention is illustrated in Fig. 4. In this case, a bipolar transistor 4 and an additional bipolar transistor 25 are formed in a portion of an epitaxial layer 9 isolated by a groove isolation structure 10. The bipolar transistor 4, groove isolation structure 10, and semiconductor body 7 comprising the epitaxial layer 9 are the same as those illustrated in Figs. 2 and 3. The additional bipolar transistor 25 comprises a base region 26, an emitter region 27, a base electrode 28, an emitter electrode 29, the collector contact region 14, and the collector electrode 17. Namely, the additional transistor 25 utilizes the collector of the bipolar transistor 4. A conductor line 30, one of many conductor lines of the IC and traversing the isolated portion, is formed as illustrated in Fig. 4.

An electrostatic separating structure 31 is formed under the conductor line 30 and between the bipolar transistor 4 and the additional bipolar transistor 25. The electrostatic separating structure 31 comprises a V-shaped insulating layer 32 which does not penetrate into the semiconductor substrate 8, a filled-in polycrystalline silicon material 33, and a relatively thick insulating layer 34. It is possible to easily form such an electrostatic separating structure 31 at the same time as the formation of the groove isolation structure 10. When a V-groove for the electrostatic separating structure 31 is formed, it is suitable to determine the depth of the V-groove by controlling the width of the exposed surface area of the epitaxial layer 9 to be etched. Since the above-mentioned electrostatic separating structure 31 exists under the conductor line 30, the stray capacity of the conductor line 30 can be substantially reduced as compared with the case where there is no electrostatic separating structure 31.

It is possible to form the electrostatic separating structure according to the present invention in a u-groove type shape, as in Fig. 5, instead of the above-mentioned V-groove type shape, as in Figs. 3 and 4. In this case, the electrostatic separating structure 35 under the conductor line 5 comprises a U-shaped insulating layer 36 extending into the semiconductor substrate 8 through the epitaxial layer 9, a filled-in polycrystalline silicon material 37, and a relatively thick insulating layer 38. A groove isolation structure 39 for the bipolar transistor 4, the same as that in Figs. 2, 3, and 4, comprises a U-shaped insulating layer 40, a filled-in polycrystalline silicon material 41, and a relatively thick insulating layer 42. Namely, the isolation structure 39 has the same shape as that of the separating structure 35. Both structures 35 and 39 can be simultaneously formed in accordance with the above-mentioned method, except that dry-etching for the U-groove is used instead of the anisotropical wet-etching for the V-groove. For example, an ion beam of argon or carbon fluoride is accelerated with a voltage of from 100 V to 10 kV and vertically bombards the exposed surface of the epitaxial layer 9 not masked by the insulating layer 6 and the silicon nitride layer (not shown), so that the exposed portion of the epitaxial layer 9 and the semiconductor substrate 8 is vertically etched to form the U-groove. The stray capacity of the conductor line 5 can be substantially reduced by the formation of the U-groove electrostatic separating structure 35.

It will be obvious that the present invention is not restricted to the above-mentioned embodiments, and that many variations are possible for a person skilled in the art without departing from the scope of the present invention. For example, it is possible to use a nonconductive material (preferably, an insulating material) such as silicon dioxide and polyimide, instead of the polycrystalline silicon material filled in the groove. In the case where the groove is filled with silicon dioxide or polyimide, a conductor line can be formed directly on the filled-in material. It is also possible to form a metal-oxide-semiconductor field effect transistor instead of the bipolar transistor.

## Claims

1. A semiconductor device having a semiconductor body (7), an isolation structure (10), elements (4) formed in a portion of the semiconductor body and surrounded by the isolation structure to isolate the elements (4) electrostatically from each other, and conductor lines (5, 30) operatively connecting the elements, characterised in that the semiconductor device is provided with an electrostatic separating structure (21, 31, 35) including a groove formed in the semiconductor body under and along those portions of each conductor line (5, 30) extending in regions of the semiconductor body other than the regions in which the elements (4) and the isolation structure (10) are formed, and a filler (22, 23; 32, 33; 36, 37) filling the groove formed in a portion of the semiconductor body, the electrostatic separating structure including an insulating material constituted by the filler or by a layer formed on the filler which contacts the conductor lines.

2. A semiconductor device according to claim 1, characterised in that the semiconductor body (7) comprises a semiconductor substrate (8) and an epitaxial layer (9) grown on the substrate (8), and in that the grooves extend into the epitaxial layer (9).

3. A semiconductor device according to claim 1 or claim 2, characterised in that the grooves extend into the semiconductor substrate (8) through the epitaxial layer (9).

4. A semiconductor device according to any of the preceding claims, characterised in that the groove is a V-groove or a U-groove.

5. A semiconductor device according to any of the preceding claims, characterised in that the filler comprises an insulating layer (22, 32, 36) formed on the surface of the groove, and a nonconductive material filling the groove.

6. A semiconductor device according to claim 5, characterised in that the insulating layer (22, 32, 36) is silicon dioxide and in that the nonconductive material comprises a polycrystalline silicon portion (23, 33, 37) and a silicon dioxide layer (24, 34, 38) formed on the polycrystalline silicon portion.

7. A method of manufacturing a semiconductor device, the method comprising forming semiconductor elements (4) in a portion of a semiconductor body; forming isolation structures (10) which surround the elements to isolate the elements (4) electrostatically from each other; forming conductor lines (5,30) on the semiconductor body characterised by forming an electrostatic separating structure (21, 31, 35) including a groove formed in the semiconductor body under and along those portions of each conductor line (5, 30) extending in regions of the semiconductor body other than the regions in which the elements (4) and the isolation structure (10) are formed, the groove being filled with a filler, whereby the electrostatic separation structure includes an insulating material constituted by the filler or by a layer formed on the filler which contacts the conductor lines.

8. A method according to claim 7, wherein the groove isolation structures (10) and the electrostatic separating stucture (21, 31, 35) are formed at the same time.

9. A method according to claim 7 or claim 8, wherein grooves of the groove isolation structures (10) and the electrostatic separating structure (21, 31, 35) are formed by etching the semiconductor body (7).

**Patentansprüche**

1. Halbleitervorrichtung mit einem Halbleiterkörper (7), einer Isolationsstruktur (10), Elementen (4), die in einem Abschnitt des Halbleiterkörpers gebildet und von der Isolationsstruktur umgeben sind, um die Elemente (4) elektrostatisch voneinander zu isolieren, und Leiterleitungen (5, 30), die wirkungsmäßig die Elemente verbinden, dadurch gekennzeichnet, daß die Halbleitervorrichtung mit einer elektrostatischen Trennstruktur (21, 31, 35) versehen ist, die eine Nut umfaßt, die in dem Halbleiterkörper unter und längs jenen Abschnitten von jeder Leiterleitung (5, 30) gebildet ist, die sich auf dem Halbleiterkörper in anderen Bereichen als denjenigen Bereichen erstrecken, in welchen die Elemente (4) und die Isolationsstruktur (10) gebildet sind, und mit einem Füller (22, 23; 32, 33; 36, 37), der die Nut füllt, die in einem Abschnitt des Halbleiterkörpers gebildet ist, wobei die elektrostatische Trennstruktur ein isolierendes Material enthält, welches aus dem Füller oder einer auf dem Füller geformten Schicht, die die Leiterleitungen berührt, besteht.

2. Halbleitervorrichtung nach Anspruch 1, dadurch gekennzeichnet, daß der Halbleiterkörper (7) ein Halbleitersubstrat (8) und eine epitaktische Schicht (9), die auf dem Substrat (8) aufgewachsen ist, umfaßt, und daß die Nuten sich in die epitaktische Schicht (9) erstrecken.

3. Halbleitervorrichtung nach Anspruch 1 oder 2, dadurch gekennzeichnet, daß die Nuten sich durch die epitaktische Schicht (9) in das Halbleitersubstrat (8) erstrecken.

4. Halbleitervorrichtung nach einem der vorhergehenden Ansprüche, dadurch gekennzeichnet, daß die Nut eine V-Nut oder eine U-Nut ist.

5. Halbleitervorrichtung nach einem der vorhergehenden Ansprüche, dadurch gekennzeichnet, daß der Füller eine Isolationsschicht (22, 32, 36), die auf der Oberfläche der Nut gebildet ist, und ein nicht leitendes Material, welches die Nut füllt, umfaßt.

6. Halbleitervorrichtung nach Anspruch 5, dadurch gekennzeichnet, daß die isolierende Schicht (22, 32, 36) Siliziumdioxid ist und das nichtleitende Material einen polykristallinen Siliziumabschnitt (23, 33, 37) und eine Siliziumdioxidschicht (24, 34, 38) umfaßt, die auf dem polykristallinen Siliziumabschnitt gebildet ist.

7. Verfahren zur Herstellung einer Halbleitervorrichtung, welches Verfahren umfaßt: die Bildung von Halbleiterelementen (4) in einem Abschnitt des Halbleiterkörpers; die Bildung von Isolationsstrukturen (10), welche die Elemente umgeben, um die Elemente (4) elektrostatisch voneinander zu isolieren; die Bildung von Leiterleitungen (5, 30) auf dem Halbleiterkörper, gekennzeichnet durch die Bildung einer elektrostatischen Trennstruktur (21, 31, 35), welche eine Nut umfaßt, die in dem Halbleiterkörper unter und längs jenen Abschnitten von jedem Leiterleitungen (5, 30) gebildet ist, die sich in anderen Bereichen des Halbleiterkörpers als jenen Bereichen erstrecken, in welchen die Elemente (4) und die Isolationsstruktur (10) gebildet werden, wobei die Nut mit einem Füller gefüllt wird, wodurch die elektrostatische Trennstruktur ein isolierendes Material enthält, welches aus dem Füller oder einer auf dem Füller geformten Schicht, die die Leiterleitungen berührt, besteht.

8. Verfahren nach Anspruch 7, bei dem die Nutisolationsstrukturen (10) und die elektrostatischen Trennstrukturen (21, 31, 35) gleichzeitig gebildet werden.

9. Verfahren nach Anspruch 7 oder 8, bei dem die Nuten der Nutisolationsstrukturen (10) und die elektrostatische Trennstruktur (21, 31, 35) durch Ätzen des Halbleiterkörpers (7) gebildet werden.

**Revendications**

1. Dispositif semiconducteur possédant un corps semiconducteur (7), une structure d'isolement (10), des éléments (4) formés dans une partie du corps semiconducteur et entourés par la structure d'isolement afin que les éléments (4) soient électrostatiquement isolés les uns des autres, et des lignes conductrices (5, 30) connectant fonctionnellement les éléments, caractérisé en ce qu'il est doté d'une structure de séparation électrostatique (21, 31, 35) comportant une rainure formée dans le corps semiconducteur au-dessous et le long des parties de chaque ligne conductrice (5, 30) s'étendant dans des régions du corps semiconducteur autres que les régions dans lesquelles les éléments (4) et la structure d'isolement (10) sont formés, et une matière de remplissage (22, 23; 32, 33; 36, 37) remplissant la rainure formée dans une partie du corps semiconducteur, la structure de séparation électrostatique comportant un matériau isolant constitué par la matière de remplissage ou une couche formée sur la matière de remplissage qui est en contact avec les lignes conductrices.

2. Dispositif semiconducteur selon la revendication 1, caractérisé en ce que le corps semiconducteur (7) comprend un substrat semiconducteur (8) et une couche épitaxiale (9) formée par croissance sur le substrat (8), et en ce que les rainures s'étendent jusque dans la couche épitaxiale (9).

3. Dispositif semiconducteur selon la revendication 1 ou 2, caractérisé en ce que les rainures s'étendent jusque dans le substrat semiconducteur (8) au travers de la couche épitaxiale (9).

4. Dispositif semiconducteur selon l'une quelconque des revendications précédentes, caractérisé en ce que la rainure est une rainure en V ou une rainure en U.

5. Dispositif semiconducteur selon l'une quelconque des revendications précédentes, caractérisé en ce que la matière de remplissage comprend une couche isolante (22, 32, 36) formée sur la surface de la rainure, et un matériau non conducteur remplissant la rainure.

6. Dispositif semiconducteur selon la revendication 5, caractérisé en ce que la couche isolante (22, 32, 36) est du dioxyde de silicium et en ce que le matériau non conducteur comprend une partie de silicium polycristallin (23, 33, 37) et une couche de dioxyde de silicium (24, 34, 38) formée sur la partie de silicium polycristallin.

7. Procédé de fabrication d'un dispositif semiconducteur, le procédé comprenant les opérations suivantes: former des éléments semiconducteurs (4) dans une partie d'un corps semiconducteur; former des structures d'isolement (10) qui entourent les éléments afin d'isoler électrostatiquement les éléments (4) les uns des autres; former des lignes conductrices (5, 30) sur le corps semiconducteur, caractérisé en ce qu'on forme une structure de séparation électrostatique (21, 31, 35) comportant une rainure formée dans le corps semiconducteur au dessous et le long des parties de chaque ligne conductrice (5, 30) s'étendant dans des régions du corps semiconducteur autres que les régions dans lesquelles les éléments (4) et la structure d'isolement (10) sont formés, la rainure étant remplie d'une matière de remplissage, si bien que la structure de séparation électrostatique comporte un matériau isolant constitué par la matière de remplissage ou par une couche formée sur la matière de remplissage qui est en contact avec les couches conductrices.

8. Procédé selon la revendication 7, où les structures d'isolement en rainure (10) et la structure de séparation électrostatique (21, 31, 35) sont formées en même temps.

9. Procédé selon la revendication 7 ou 8, où les rainures des structures d'isolement en rainure (10) et de la structure de séparation électrostatique (21, 31, 35) sont formées par incision du corps semiconducteur (7).

Fig. 1

# Fig. 2

# Fig. 3

## EP 0 086 915 B1

# Fig. 4

# Fig. 5